# EUROPEAN PATENT APPLICATION

(11) **EP 2 273 579 A1**
(43) Date of publication of application: **12.01.2011**
(21) Application number: 09165256.0
(22) Date of filing: 10.07.2009
(51) Int. Cl.: H01L 51/52

(54) **A method of encapsulating a flexible optoelectronic multi-layered structure**

(71) Applicant: Nederlandse Organisatie voor Toegepast -Natuurwetenschappelijk Onderzoek TNO, 2628 VK Delft (NL); Koninklijke Philips Electronics N.V., 5621 AE Eindhoven (NL)
(72) Inventor: Van de Weijer, Peter, 5591 PW Heeze (NL); Van Mol, Antonius Maria Bernardus, 5658 HC Eindhoven (NL); Tanase, Cristina, 5581 CG Waalre (NL)
(74) Representative: Hatzmann, Martin

(57) **Abstract**

The invention relates to a method of encapsulating a flexible optoelectronic multi-layered structure (6) provided on a polymer substrate (2) comprising the steps of providing the flexible optoelectronic multi-layered structure with one or both a bottom encapsulation stack (B) and a top encapsulation stack (T),
wherein the bottom encapsulation stack and the top encapsulation layer comprise a first inorganic layer (4a, 8a) separated from a second inorganic layer (4b, 8b) by a substantially continuous getter layer (5, 8) comprising a metal oxide, the first and the second inorganic layers having an intrinsic water vapour transmission of 10⁻⁵ g.m⁻².day⁻¹ or less.

## Description

### FIELD

The invention relates to a field of encapsulation of layered structures for preventing moisture from environment from penetrating into the layered structures. In particular, the invention relates to a method of encapsulation of a flexible optoelectronic layered structure, such as a photovoltaic cell or a light emitting OLED.

### BACKGROUND

Exposure of organic light emitting devices (LEDs) to the ambient atmosphere results in inhomogeneous degradation of device operational characteristics. For example, in organic light emitting devices (OLEDs) water, or water vapours may penetrate into the device through pinholes in the cathode that may be caused by dust or processing particles. Water may oxidise the metal-organic interface, thus inhibiting electron injection causing place-dependent deterioration of light emission, which may be perceived as black spots in electroluminescence. The area of such black spots grows linearly with time. Therefore, in order to mitigate adverse influence from the ambient environment, encapsulation of an optoelectronic the multi-layered structure, such as OLED is required.

An embodiment of a method of encapsulating a layered structure is known from WO 2006/082111. In the known method a rigid substrate, for example a glass substrate is used for supporting a multi-layered structure of an organic electro-optical element, wherein the multi-layered structure is covered with a continuous getter layer, for example a layer of CaO or BaO. The CaO or the BaO getter layer is thereby used for counteracting penetration of moisture and/or oxygen from the environment into the multi-layered structure from one side. Due to the fact that the multi-layered structure is deposited on a rigid substrate having no significant water vapour transmission rate, such as glass, no getter layer is required at the bottom of the multi-layered structure as the substrate acts as a suitable encapsulation against moisture and/or oxygen.

It is a disadvantage of the known method that it is applicable only for the multi-layered structured deposited on a rigid substrate having no significant water vapour transmission rate. In the context of the present application the term 'no significant water vapour transmission rate' relates to intrinsic rates below 10⁻⁵ g/m²/day, whereas the term 'sufficient water vapour transmission rate' relates to intrinsic rates above 10⁻⁵g/m²/day.

### SUMMARY OF THE INVENTION

It is an object of the invention to provide a method for encapsulating an optoelectronic flexible multi-layered structure, which substantially does not deteriorate its properties. In particular optical emission characteristics of a light emitter, such as an OLED are substantially preserved, including but not limited to polymer based organic light emitting devices (PLEDs) and small molecule based light emitting devices (SMOLEDs).

To this end the method of encapsulating a flexible optoelectronic multi-layered structure supported by a polymer substrate, comprises the steps of:
providing the optoelectronic multi-layered structure with one or both a bottom encapsulation stack and a top encapsulation stack, wherein the bottom encapsulation stack and the top encapsulation layer comprise:
   a first inorganic layer separated from a second inorganic layer by a substantially continuous getter layer comprising a metal oxide, the first and the second inorganic layers having an intrinsic water vapour transmission of 10⁻⁵ g/m²/day or less depending on the required lifetime of the device.

In case of pinhole free layers a WVTR of 10⁻⁵ g/m²/day or less may be necessary to ensure a lifetime of 1 year as discussed in reference Peter van de Weijer, Gerard Rietjens, Cristina Tanase et al., "Thin film encapsulation of organic LEDs," Proc. of OSC 08: Frankfurt, 2008.

It is found that inferior properties of flexible substrates related to water vapour transmission rate may successfully be mitigated by providing an encapsulation stacks between the substrate and a suitable optoelectronic device, such as a light emitting structure, wherein the encapsulation stack comprises a substantially continuous getter layer sandwiched between a first inorganic layer and a second inorganic layer having low WVTR.

It will be appreciated that various configurations are envisaged. First, it is possible that the optoelectronic structure, such as an OLED or PV device, or more particularly a bottom emitting OLED is sandwiched between a bottom encapsulation stack and a top encapsulation stack, each encapsulation stack comprising a first inorganic layer separated from a second inorganic layer by a substantially continuous getter layer comprising a metal oxide, the first and the second inorganic layers having an intrinsic water vapour transmission in the range of 10⁻⁵ g.m⁻².day⁻¹ or less.

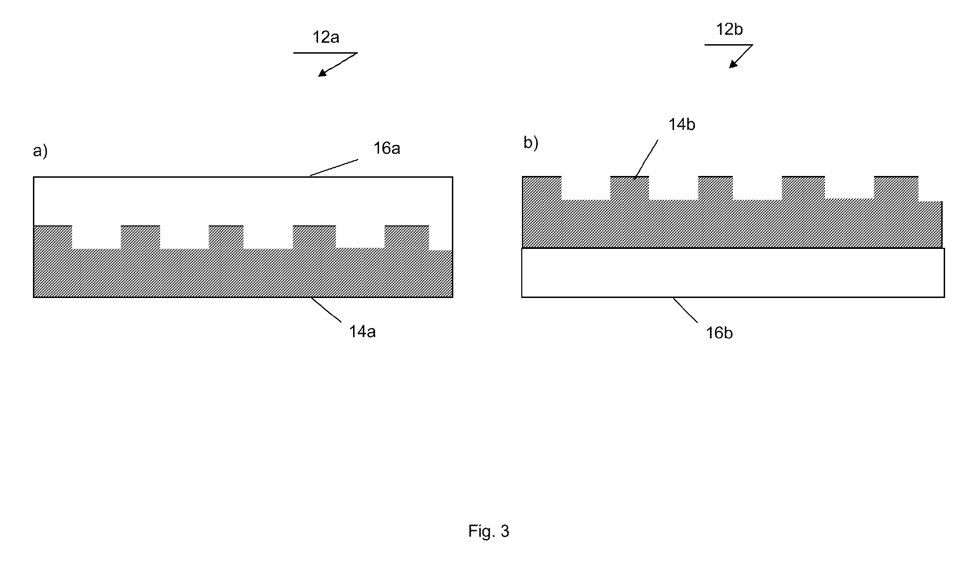

Alternatively, it is possible that the optoelectronic structure is provided solely with a top encapsulations stack, for example wherein the light emitting structure is a top emitter. In this case protection from the environment from below may be achieved by further means, for example by using a metal substrate below the top emitter. This embodiment is schematically discussed with reference to Figure 3.

The technical measure of the invention is based on the insight that a multi-layer barrier stack must be provided for an optoelectronic device supported by a polymer flexible foil, as a single barrier layer would not suffice because it is essentially impossible to deposit a thin layer without any pin holes on large areas in the order of m². The pinholes thus incorporated in a thin layer during deposition thereof conduct water vapour inside the multilayer structure thereby deteriorating properties thereof.

In accordance to the invention it is found that by using an encapsulation stack comprising a substantially continuous metal oxide getter layer between the first inorganic layer and the second inorganic layer both having substantially low water vapour transmission rate (WVTR) improved encapsulation results are obtained. Preferably, inorganic layers having intrinsic, i.e. not taking pinholes into account, WVTR in the range of 10⁻⁵ g.m⁻².day⁻¹ or below are used. Those skilled in the art would appreciate which inorganic materials are suitable for this purpose.

It is further found that despite the low WVTR such inorganic layers would still comprise a certain, although low, amount of pin holes. In order to mitigate effects of these pin holes a substantially continuous getter layer comprising a metal oxide is provided. For example, metal oxide may be used for material of the getter layer, which may be selectable from a group consisting of CaO, BaO, ZnO, or CdO. It will be appreciated that material of the getter layer of the bottom encapsulation stack may be the same as material of the getter layer of the top encapsulation stack.

In an embodiment of the method according to the invention the bottom encapsulation stack and/or the top encapsulation stack comprise an organic layer between the first inorganic layer and the second inorganic layer.

It is found that by providing an organic layer in the encapsulation stack between the first inorganic layer and the second inorganic layer a number of pin holes in the second inorganic layer may be substantially decreased. Preferably, an organic layer is provided between the first inorganic layer and the getter layer. As a result durability of the flexible light emitting structure may be increased.

In a still further embodiment of the invention, wherein the flexible optoelectronic multi-layered structure is a bottom-emitting OLED, an anode layer thereof is used for the second inorganic layer of the bottom encapsulation stack.

It is found that layers of the OLED structure may be used for encapsulation. For example, a metal cathode layer may used for the inorganic layer. Accordingly, such cathode layer may be used for an inorganic layer of the encapsulation stack. As a result, the number of layers to be deposited for the encapsulation layer may be decreased.

It will be appreciated that in case of the bottom-emitter the light is transmitted through the bottom encapsulation layer and the polymer substrate. In order preserve the light output the getter layer of the bottom encapsulation stack is optically transparent for at least 50%, preferably for at least 80%.

It will be appreciated that the method of encapsulation according to the invention may also be applied to a top-emitter, and a transparent OLED. In this case the getter layer of the top encapsulation stack is optically transparent for at least 50%, preferably for at least 80%.

In a still further embodiment of the method according to the invention, it further comprises the step of depositing a planarization layer on the flexible polymer substrate before arranging the encapsulation stack thereon.

It is found that deposition of the planarization layer is advantageous as creation of pinholes due to dust particles present, for example, on the polymer substrate may further be mitigated.

In a still further embodiment of the method according to the invention the getter layer is patterned for increasing capacity.

It is found to be particularly advantageous to provide a patterned getter layer, particularly a patterned optically transparent getter, as thickness of such layer may be critical, for example, to the light output of the OLED. Preferably, such patterned getter layer comprises a thin layer of a metal oxide provided with a thick patterned layer of a further getter material. Depending on a position with respect to the light emitting portions of the emitting multi-layered structure, the thick patterned getter may be transparent or non transparent.

In a still further embodiment of the method according to the invention the flexible optoelectronic multi-layered structure is an OLED comprising a non-emitting region, the optically transparent getter layer being patterned in a portion spatially overlapping said region.

It is found to be particularly advantageous to utilize regions of such multi-layered structure, like regions corresponding to conductive paths, which are non-emitting for depositing thick (less transparent) getter material. As a result a total capacitance of the getter layer may be substantially increased without deteriorating optical properties of the light emitting multi-layered structure. For example, the light emitting multi-layered structure may relate to an OLED. Furthermore, instead of a light emitting structure also a photoactive structure such as used in photovoltaic cells benefit from such barrier structures.

An optoelectronic device according to the invention comprises a flexible polymer substrate and an optoelectronic multi-layered structure provided with one or both a bottom encapsulation stack and a top encapsulation stack, wherein
the bottom encapsulation stack and the top encapsulation stack comprises
a first inorganic layer separated from a second inorganic layer by a substantially continuous getter layer comprising a metal oxide, the first and the second inorganic layers having an intrinsic water vapour transmission in the range of 10⁻⁵ g.m⁻².day⁻¹ and lower.

It is found that the optoelectronic device as is set forth in the foregoing has superior durability due to improved encapsulation. This is achieved by suppressing a number of pin holes and by intercepting water vapour penetrated the structure through the pin holes by the getter layer.

In an embodiment of the optoelectronic device an organic layer is provided between the first inorganic layer and the second inorganic layer, preferably between the first inorganic layer and the getter layer.

In this case the encapsulation stack may comprise a first inorganic layer, for example, a SiN layer, an organic layer, a getter layer, for example a BaO layer and a second inorganic layer. It is found that the provision of the organic layer in the encapsulation stack further decreases a number of pin holes in the inorganic layer. It will be appreciated that for the getter layer a metal oxide layer, preferably, selected from a group consisting of CaO, BaO, ZnO, CdO may be used.

In a still further embodiment according to the invention a substantially continuous getter layer conceived to intercept light emanating from the flexible light emitting multilayer structure is at least 50% transparent for visible light, preferably at least 80% transparent for visible light. It will be appreciated that for the bottom emitter, such as an OLED, the getter layer of the bottom encapsulation stack is transparent, whereas for the top-emitter the getter layer of the top encapsulation stack is transparent. It will further be appreciated that the getter layer conceived to intercept light may be partially transparent, i.e. it may be transparent only at regions when such functionality is required.

In a still further embodiment of the optoelectronic device a light emitter is contemplated wherein the light emitting multi-layered structure comprises a non-emitting region, the optically transparent getter layer may be patterned in a portion spatially overlapping said region. For example, the light emitting structure may relate to an OLED or a small molecule OLED. It will be appreciated that in the context of the present application the terms "OLED" and a small molecule "OLED" may be interchanged, provided the context allows it.

In a still further embodiment of the optoelectronic device according to the invention a cathode layer and/or inorganic anode layer of a bottom emitting OLED are used for the respective inorganic layers of the respective top or bottom encapsulation stacks. It is found that by doing so the bottom encapsulation stack may be partially integrated with the light emitting structure, as an inorganic layer of the encapsulation stack is shared with a functional layer of the light emitting structure.

These and other aspects of the invention will be discussed in more detail with reference to drawings, wherein like reference numerals refer to like elements. It will be appreciated that the drawings are presents for illustrative purposes and may not be used for limiting the scope of the appended claims.

### BRIEF DESCRIPTION OF THE DRAWINGS

Figure 1 presents in a schematic way an embodiment of a device according to the invention comprising a flexible bottom emitting multi-layered structure.
Figure 2 presents schematically an embodiment of a top emitting multi-layered structure.
Figure 3 presents schematically an embodiment of a patterned optically transparent getter layer according to an aspect of the invention.

### DETAILED DESCRIPTION OF THE DRAWINGS

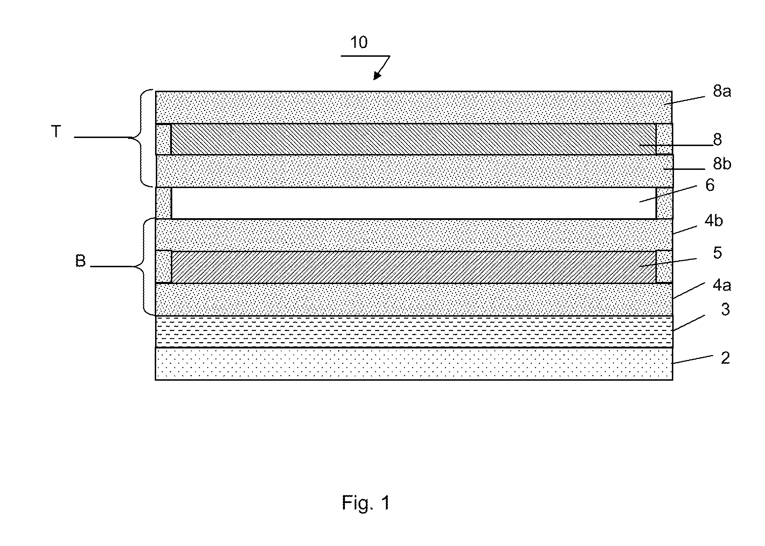

Figure 1 presents in a schematic way an embodiment a device 10 structure according to an aspect the invention, said structure comprising a flexible bottom emitting multi-layered structure. For example, the device 10 may relate to a bottom emitting OLED, or a photovoltaic cell.

The device 10 comprises a flexible polymer substrate 2, for example a suitable polymer foil, which may have a significant water vapour transmission rate due to its physical nature. The flexible substrate 2 may, however, also relate to a metal foil for a top-emitter, for example. On top of the flexible substrate 2 a planarization layer 3 may be deposited. In order to protect a bottom emitting multi-layered structure 6 from environment, the device 10 according to the invention is sandwiched between a bottom encapsulation stack B and a top encapsulation stack T. The bottom encapsulations stack B comprises a first inorganic layer 4a separated from a second inorganic layer 4b by a substantially continuous getter layer 5 comprising a metal oxide, the first and the second inorganic layers having an intrinsic water vapour transmission in the range of 10⁻⁵ to 10⁻⁸ g.m⁻².day⁻¹. The top encapsulations stack T comprises a first inorganic layer 8a separated from a second inorganic layer 8b by a substantially continuous getter layer 8 comprising a metal oxide, the first and the second inorganic layers having an intrinsic water vapour transmission in the range of 10⁻⁵ g.m⁻².day⁻¹ or below. It will further be appreciated that the top encapsulation stack and/or the bottom encapsulation stack may comprise one or more dyads formed of an inorganic layer, for example SiN, and an organic layer. Due to incorporation of such dyads encapsulation properties are still further improved.

It will be appreciated that for a bottom emitter between the first inorganic layer 4a and the second inorganic layer 4a the bottom encapsulation stack B may comprise:
i) an organic layer (not shown) and a substantially transparent continuous getter layer 5;
ii) only a substantially transparent getter layer 5.

The top encapsulation stack T may be formed similarly, except for the getter layer 5 which may be not transparent.

The getter layers 5 and 8 may comprise a metal oxide, such as CaO, BaO, ZnO or CdO. These materials may be deposited using thermal evaporation, wherein a typical thickness of such layer may be about 100 nm.

Preferably, for the low WVTR inorganic layers SiN is selected. It will, however, be appreciated that any other suitable inorganic materials may be selected for this purpose. Those skilled in the art will readily appreciate which inorganic layers may be applied for forming a flexible light emitting device.

The bottom emitting structure 6 of the device 10 comprises an inorganic cathode layer, an emitting layer and an anode layer (all not shown). It will be appreciated that a structure of a bottom emitting OLED or a bottom emitting small molecule OLED is known per se.

In accordance with an aspect of the invention the anode layer, which is usually manufactured from Indium-Tin oxide, may be used for a second inorganic layer 4b of the bottom encapsulation stack B.

It will further be appreciated that in case the light emitting structure 6 relates to a bottom emitter, the first substantially continuous getter layer is transparent at regions coinciding with light exit regions. However, when the light emitting structure 6 is a top emitter, the getter layer of the top encapsulation stack T is transparent at least at regions coinciding with light exit regions. However, in both cases the getter layer 8 should be sandwiched between two inorganic layers of the encapsulation stack.

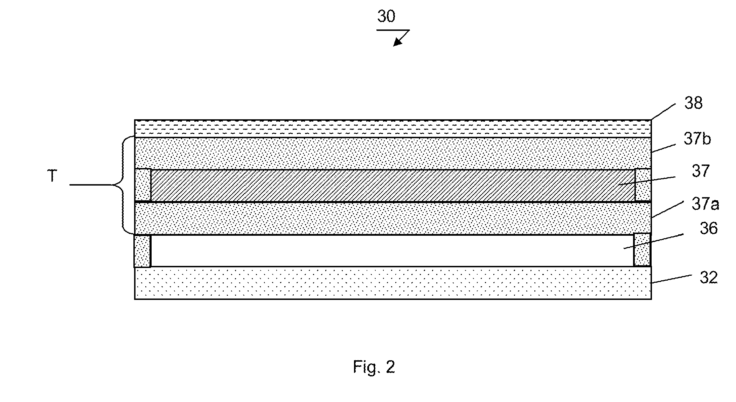

Figure 2 presents schematically an embodiment of a top emitting multi-layered structure. A device 30 may comprise a top-emitting multi-layer structure 36, for example a top-emitting OLED. In this case the device 30 may comprise a substrate 32 terminating with a metal layer or consisting of a metal foil facing the multi-layered structure 36 followed by a substantially continuous getter layer 37 sandwiched between a first inorganic layer 37a and a second inorganic layer 37b. Optionally, the device 30 may comprise a functional layer 38 arranged for protecting the device 30 from mechanical damage, like scratching and/or from UV radiation. In this case the top encapsulation stack T is formed by the layers 37a, 37b and 37, according to the insights as is discussed in the foregoing. It will be appreciated that also in this case the top encapsulation stack may comprise an organic layer between the inorganic layers for decreasing the effect of pin holes.

Figure 3 presents schematically an embodiment of a patterned optically transparent getter layer according to an aspect of the invention. In view "a" a structure 12a is shown, wherein a patterned metal oxide getter layer 14a, as is discussed with reference to Figure 1, is provided with a planarization layer 16a. It will be appreciated that patterning of the layer 14a may be achieved using suitable lines, crossings, dots or the like.

In view "b" a further structure 12b is depicted comprising a planarization layer 16b on top of which a patterned metal oxide getter layer 14b is provided.

It will be appreciated that the patterned getter layer may comprise a transparent region (CaO, BaO, or the like) and a non-transparent region, which may comprise Ba, zeolites, silica, organic molecules, etc. The non-transparent getter material may be applied at regions corresponding to non-emitting areas of the OLED, such as regions corresponding to electrically conductive lines.

It will be appreciated that while specific embodiments of the invention have been described above, that the invention may be practiced otherwise than as described. In addition, isolated features discussed with reference to different figures may be combined.

## Claims

1. A method of encapsulating a flexible optoelectronic multi-layered structure supported by a polymer substrate, comprising the steps of:
providing the flexible optoelectronic multi-layered structure with one or both a bottom encapsulation stack and a top encapsulation stack,
wherein the bottom encapsulation stack and the top encapsulation layer comprise:
a first inorganic layer separated from a second inorganic layer by a substantially continuous getter layer comprising a metal oxide, the first and the second inorganic layers having an intrinsic water vapour transmission of 10⁻⁵ g.m⁻².day⁻¹ or less.

2. A method according to claim 1, wherein the optoelectronic multi-layered structure comprises a photovoltaic multi-layered structure.

3. A method according to claim 1, wherein the optoelectronic multi-layered structure comprises a light emitting structure.

4. A method according to claim 1, 2 or 3, wherein the bottom encapsulation stack and/or the top encapsulation stack comprise an organic layer between the first inorganic layer and the second inorganic layer.

5. A method according to claim 4, wherein the organic layer is provided between the first inorganic layer and a getter layer.

6. A method according to any one of the preceding claims, wherein the first inorganic layer and the second inorganic layer comprise silicon nitride.

7. A method according to any one of the preceding claims, wherein the top encapsulation layer and/or the second encapsulation layer comprise one or more twin-structures layers formed of an inorganic layer and an organic layer.

8. A method according to any one of the preceding claims 3 - 7,
wherein the light emitting structure is a bottom-emitting OLED, an inorganic anode layer and/or an inorganic cathode layer thereof being used for an inorganic layer of the bottom encapsulation stack, or the top encapsulation stack, respectively.

9. A method according to claim 8, wherein a getter layer of the bottom multi-layered encapsulation stack is optically transparent for at least 50%, preferably for at least 80%.

10. A method according to any one of the preceding claims 3 - 7, wherein the flexible multi-layered structured is a top-emitting OLED, wherein the getter layer of the top encapsulation stack is optically transparent for at least 50%, preferably for at least 80%.

11. A method according to any one of the preceding claims, further comprising the step of depositing a planarization layer on the flexible polymer substrate.

12. A method according to any one of the preceding claims, wherein material of the second substantially continuous getter layer is the same as material of the first substantially continuous getter layer.

13. A method according to claim 9 or 10, wherein the getter layer is patterned for increasing capacity.

14. A method according to claim 13, wherein the flexible multi-layered structure comprises a non-emitting region, the optically transparent getter layer being patterned in a portion spatially overlapping said region.

15. A method according to any one of the preceding claims, wherein the metal oxide is selectable from a group consisting of CaO, BaO, ZnO, or CdO.

16. An optoelectronic device comprising a flexible polymer substrate and a flexible optoelectronic multi-layered structure comprising one or both a bottom encapsulation stack and a top encapsulation stack, wherein
the bottom encapsulation stack and the top encapsulation stack comprises
a first inorganic layer separated from a second inorganic layer by a substantially continuous getter layer comprising a metal oxide, the first and the second inorganic layers having an intrinsic water vapour transmission of 10⁻⁵ g.m⁻².day⁻¹ or less.

17. A device according to claim 16, wherein an organic layer is provided between the first inorganic layer and the second inorganic layer, preferably between the first inorganic layer and the getter layer.

18. A device according to claim 16 or 17, wherein material of the first substantially continuous getter layer or material of the second substantially continuous getter layer is selected from a group consisting of: CaO, BaO, ZnO, CdO.

19. A device according to any one of the preceding claim 16 - 18, wherein a substantially continuous getter layer conceived to intercept light emanating from the flexible light emitting multilayer structure is at least 50% transparent for visible light, preferably at least 80% transparent for visible light.

20. A device according to claim 19, wherein the light emitting multi-layered structure comprises a non-emitting region, the optically transparent getter layer being patterned in a portion spatially overlapping said region.

21. A device according to any one of the preceding claims 16 - 20,
wherein the light emitting multi-layered structure comprises an OLED.

22. A device according to claim 21, wherein for a bottom emitting OLED an inorganic anode layer or an inorganic cathode layer thereof is used for the second inorganic layer.
